Europäisches Patentamt

European Patent Office

Office européen des brevets

(11) Publication number: **0 162 165**
**A2**

(12) # EUROPEAN PATENT APPLICATION

(21) Application number: **84303845.6**

(22) Date of filing: **07.06.84**

(51) Int. Cl.⁴: **H 01 L 43/06**

(30) Priority: **10.06.83 US 502905**

(43) Date of publication of application:
**27.11.85 Bulletin 85/48**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Carvajal, Fernando**
**461 Windmill Lane**
**McKinney Texas(US)**

(72) Inventor: **Trogolo, Joe R.**
**2712 Glen Forest**
**Plano Texas(US)**

(74) Representative: **Abbott, David John et al,**
**Abel & Imray Northumberland House 303-306 High**
**Holborn**
**London, WC1V 7LH(GB)**

(54) Hall effect device.

(57) A semiconductor Hall effect device having a stable and more controllable offset voltage is formed, in one embodiment, of an N-type silicon epitaxial layer 12 overlaying a P-type silicon substrate, 24 and a P+-type region is formed, for example, by ion implantation, in the surface of the epitaxial layer 12 over the active area of the Hall element. The P+-type region 26 effectively shields the surface of the Hall element to prevent induced surface potential variations. Current and voltage sense contacts are provided by N+-type shield region 26 to contact the N-type epitaxial layer 12.

Fig. 7

EP 0 162 165 A2

## HALL EFFECT DEVICE

BACKGROUND OF THE INVENTION

The present invention relates generally to Hall effect devices and more particularly to an improved Hall effect device that is integratable on a semiconductor chip.

The Hall effect is based on the fact that a charge moving in a magnetic field experiences a Lorentz force proportional to the magnitudes of the applied current and magnetic field. If a metal or semiconductor material carrying a current is placed in an orthogonal magnetic field, an electric field is induced within the material in a direction which is mutually perpendicular to both the current and the magnetic field. The Lorentz force tends to cause the current carriers, i.e., electrons or holes, to accumulate closer to one surface of the material. Since equilibrium must be maintained within the system there is also a charge generated by the accumulated static field which equals the Lorentz force. Therefore a potential difference, the Hall voltage, appears between opposite surfaces of the material.

The use of the Hall effect in semiconductor integrated circuits for linear and switching applications is well known in the art. Practical Hall devices must exhibit high sensitivity, wide operating temperature range, insensitivity to mechanical stress, and durability. Improvements in silicon technology have made it possible to overcome the low mobility and poor sensitivity of silicon by fabricating circuits in which Hall effect generators, preamplifiers, signal conditioning circuits and trigger circuits are integrated on the same semiconductor chip. See, for example, U.S. Patent No. 4,141,026 to Bate et al., entitled "Hall Effect Generator".

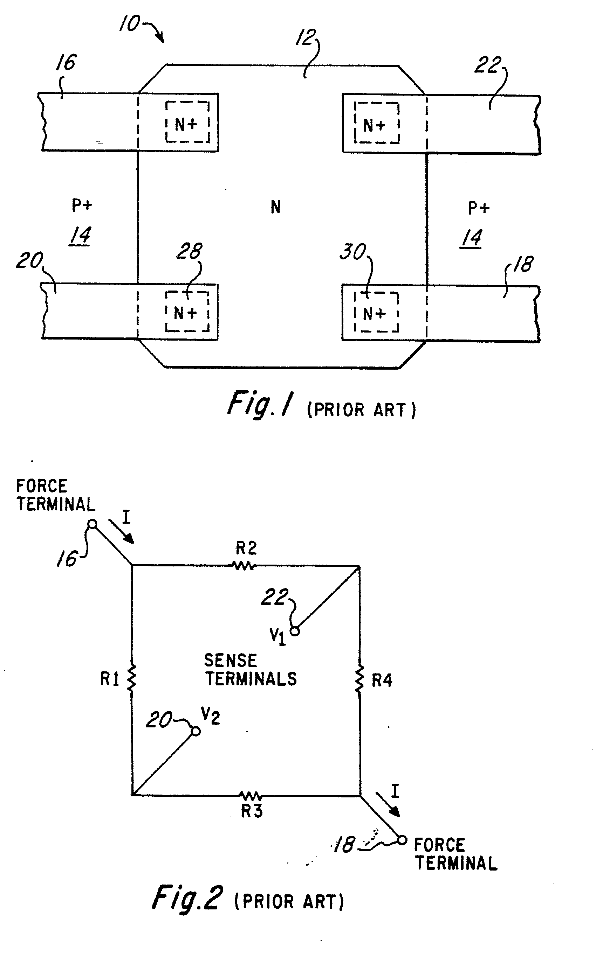

The topology of a typical Hall element structure is shown in Figure 1, wherein the silicon Hall generator 10 is formed of an N-type epitaxial region 12 surrounded by a P+
-type isolation region 14. An insulating layer such as
silicon dioxide overlying regions 12 and 14 has openings
therein to allow conductors to contact N+ -type regions
formed in the surface of region 12. The conductors form the
current, or force, terminals 16, 18 and the voltage sense
terminals 20, 22 of the Hall device. With no magnetic field
applied the Hall device 10 can be modeled as a resistor
bridge as shown in Figure 2. In an ideal device R1 = R2 and
R3 = R4, which results in an offset voltage $V_{os} = V_2 - V_1$
= 0.

Variations in the potential on the surface of the
silicon dioxide layer will induce variations in the
resistance of the underlying silicon. For example, a
negative surface potential that is less than the flatband
voltage will deplete the N-type silicon surface resulting in
a reduction in the thickness of the neutral region in the
epitaxial layer, thereby locally increasing the resistance.
Conversely, a surface potential greater than the flatband
voltage will accumulate the underlying silicon surface
resulting in a localized reduction in resistance due to
increased conductivity. These resistance changes directly
affect the offset voltage.

The offset voltage in prior devices varies
unpredictably from device to device and is sensitive to
mechanical stress. Further, temperature-induced stress is a
problem, particularly with plastic encapsulated devices.
Linear Hall effect integrated circuits typically exhibit an
output drift equivalent to an input of 4 - 10 gauss per
degree C. These offset voltage instabilities severely limit
the usefulness of semiconductor Hall effect devices.

## SUMMARY OF THE INVENTION

Accordingly, the present invention overcomes many of the aforementioned disadvantages by providing a semiconductor Hall effect device having a stable, more controllable offset voltage.

In one embodiment of the present invention a Hall device is formed in an N-type epitaxial layer overlying a P-type substrate, and a P+ -type region is formed, for example, by ion implantation, in the surface of the epitaxial layer over the active area of the Hall element. The P+ -type region effectively shields the surface of the Hall element to prevent induced surface potential variations. Current and voltage sense contacts for the Hall device are provided by N+ -type regions which penetrate through the P+ -type shield region to contact the N-type epitaxial layer.

It is therefore an object of the present invention to proviede a more reliable semiconductor Hall effect device having a stable offset voltage.

Another object is to provide a silicon Hall effect device including a surface potential shielding layer at the surface of the active Hall element.

Still another object is to provide a silicon Hall element formed in an N-type epitaxial layer having a P+ -type ion implanted layer to shield the surface of the epitaxial layer from induced surface potential variations.

## BRIEF DESCRIPTION OF THE DRAWINGS

Other objects and many of the attendant advantages of the present invention will become apparent, and the invention will be better understood by reference to the following detailed description with the accompanying drawings, wherein:

Fig. 1 is a top plan view of a Hall effect device according to the prior art;

Fig. 2 is a schematic diagram of a resistor model of the device of Fig. 1;

Figs. 3 - 7 are cross-sectional views of a Hall effect device according to the present invention showing the device at various stages of fabrication; and

Fig. 8 is a graphical representation of potential as a function of distance from the device surface, illustrating the effect of the shielding layer in reducing induced potential.

## DETAILED DESCRIPTION OF THE PREFERRED EMBODIMENT

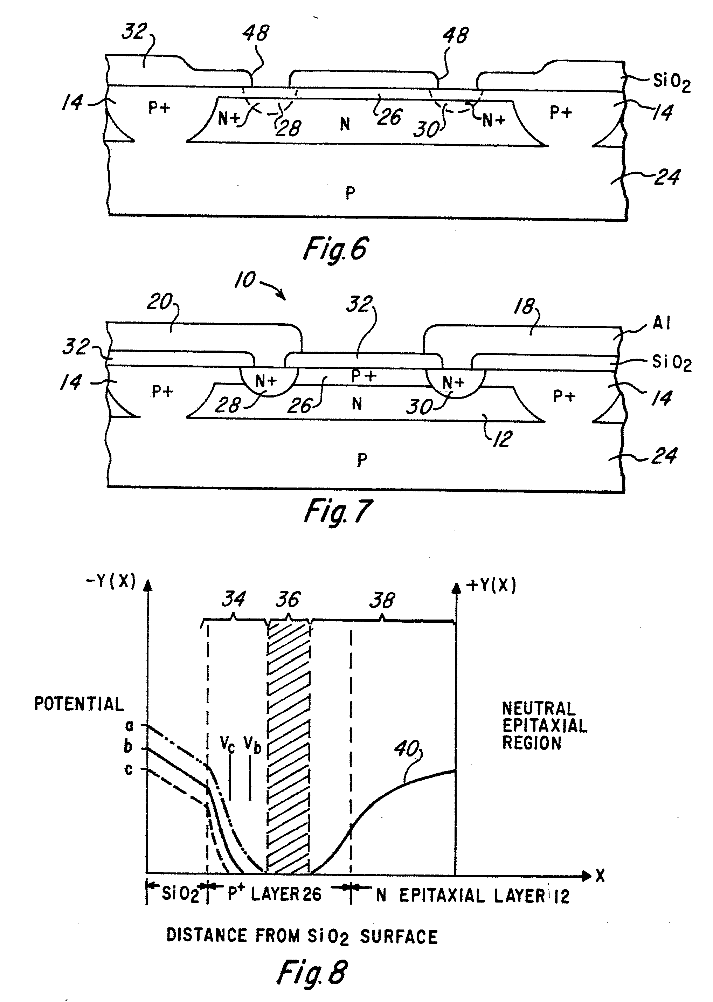

Referring now to the drawings, there is shown in Fig. 1 a top plan view of a typical Hall device as described hereinabove. A Hall device according to the present invention may conveniently be fabricated with the same surface topology. Referring to Fig. 7, there is shown a cross-sectional view in elevation of a completed device according to one embodiment of the invention. For clarity of illustration, similar reference numerals are employed in Figs. 1 and 7 to denote similar elements of the respective devices.

The silicon Hall effect device 10 is formed in an N-type epitaxial layer 12 overlying a P-type substrate 24. A P+ -type region 14 formed by conventional methods extends to the surface of substrate 24 and isolates a portion of layer 12 which will form the active Hall element. A relatively thin P+ -type region 26 at the surface of layer 12 overlies the Hall element and preferably overlaps the surrounding isolation region 14. Current and voltage sense contacts for the Hall element are provided by N+ -type regions which penetrate through region 26 and contact the underlying epitaxial layer 12. N+ -type region 28 is one of the voltage sense contacts and region 30 is one of the current contacts. An insulating layer 32, for example, silicon dioxide, overlies the Hall element and includes openings therethrough to the N+ -type regions 28, 30. A patterned conductive layer, for example, aluminum, overlies layer 32 and contacts regions 28 and 30 to form the terminals for the completed Hall device. Voltage sense sense terminal 20 and current terminal 18 are shown in Fig. 7.

The effect of the P+ -type shielding region 26 may be better understood by reference to Fig. 8, which is a graphical representation of induced potential in the device as a function of distance from the surface of silicon dioxide layer 32. Curves "a, "b" and "c" are potential profiles for three surface potentials $V_a$, $V_b$ and $V_c$ on layer 32. Region 34 is the surface depletion region of P+ -type layer 26 due to the induced potentials, cross-hatched region 36 is the neutral region of layer 26 which is unaffected by the surface potential, and region 38 is the depletion region of the remaining portion of layer 26 and a portion of the N-type epitaxial layer 12 due to an applied bias voltage. Curve 40 represents a typical potential profile for a Hall effect sensor, which is unaffected by any silicon dioxide layer 32 surface potential. The width of the neutral region 36 of layer 26 will vary depending upon the initial potential at the surface of layer 32. For example, in the case of curve "a" corresponding to potential $V_a$, the width of region 36 is that of the cross-hatched area, i.e., the neutral region 36 beings at the point where $V_a$ is zero or the x-intercept of curve "a". It follows that the width of region 36 increases for lower surface potentials $V_b$ and $V_c$, the width corresponding to the x-intercepts of curves "b" and "c", respectively.

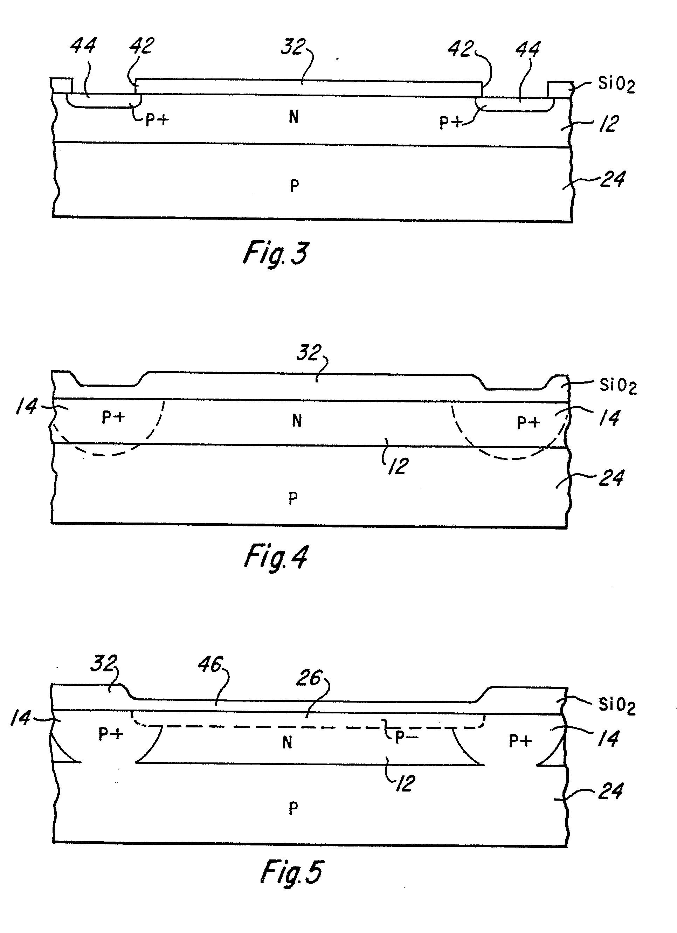

Referring now to Figs. 3 - 7, a Hall effect device according to the present invention is fabircated by starting with a P-type silicon substrate 24 having a ⟨111⟩ crystallographic orientation and a resistivity of about 10 - 20 ohm-cm. An N-type epitaxial layer 12 having a resistivity of about 1 - 10 ohm-cm. is deposited on substrate 24 to a thickness of approximately 5 - 50 microns. While an N-type substrate 24 and a P-type epitaxial layer 12 may be used, an N-type epitaxial layer is preferred because of the greater mobility of electrons which results in a greater Hall sensitivity. A silicon dioxide layer 32 is next formed on layer 12, for example, by thermal oxidation, to a thicknes of about 7000 Angstroms and patterned by conventiona photolithographic methods to form openings 42 therei exposing the surface of layer 12. A P+ -type dopant such a boron is then deposited through openings 42 to form region 44, which are then thermally diffused to form isolation regions 14 extending to the surface of substrate 24 as shown by the dashed lines in Fig. 4. Silicon dioxide is regrown in openings 42 during the diffusion process. Oxide isolation may be used instead of junction isolation to form the active Hall region, however, junction isolation is preferred because of its ease of fabrication.

Referring to Fig. 5, an opening is formed in silicon dioxide layer 32 over the surface of epitaxial layer 12 and overlapping a portion of the isolation region 14. The oxide is then regrown to a thickness of about 3000 Angstroms in region 46 of layer 32 to form a mask to reduce damage during the subsequent implantation step. The P+ -type shield region 26 is next formed by ion implantation of boron, for example, at about 110 KeV and a dose of about $10^{13} - 10^{14}$ atoms/cm$^2$. N+ -type contact regions 28, 30 are formed as shown in Fig. 6 by forming openings 48 in layer 32 and diffusing phosphorus at a temperature of about 1000 - 1100°C. to a junction depth of about 1 - 5 microns and a sheet resistivity in the range of 2 - 10 ohm-cm. The final depth of P+ -type region 26 will be about 0.5 - 2.0 microns. The Hall device is ocmpleted by removing any oxide regrown in openings 48 and forming conductors 18, 20, e.g., by aluminum evaporation, patterning and sintering.

It is important that the dopant concentration of layer 26 be light enough so that the N+ -type regions 28, 30 can penetrate layer 26 to contact epitaxial layer 12. Also, the N-to-P avalanche breakdown voltage must be greater than that required by the associated circuits formed on the same chip. Finally, the surface concentration of layer 26 must be such that the MOS inversion threshold voltage is greater than the Hall operating voltage to prevent inversion of the P+ -type layer, and the dopant concentration must be heavy enough to provide an effective shield against variations in the layer 32 surface potential as described above.

It will be apparent that the foregoing process permits associated devices and circuits to readily be formed concurrent with the fabrication of the Hall element to provide a completely integrated linear Hall sensor or Hall switching circuit.

Other embodiments and modifications of the present invention will readily come to those skilled in the art having the benefit of the foregoing description and drawings. It is therefore to be understood that such modifications and embodiments are intended to fall within the spirit and scope of the appended claims.

CLAIMS

WHAT IS CLAIMED IS:

1. An integrated Hall effect device comprising:

a semiconductor substrate of one conductivity type;

a semiconductor layer of the opposite conductivity type overlying said substrate;

an isolation region formed in said semiconductor layer and extending from the surface thereof to the surface of said substrate, said isolation region surrounding a first region of said semiconductor layer;

a second region of said one conductivity type formed in said first region extending a predetermined depth beneath the surface thereof; and

a plurality of spaced apart third regions of said opposite conductivity type formed in said second region wherein said third regions extend below the lower surface of said second region to contact said first region of said semiconductor layer, said third regions forming the current and voltage sense contacts of said Hall effect device.

2. The Hall effect device of Claim 1 wherein said isolation region comprises a semiconductor region of said one conductivity type.

3. The Hall effect device of Claim 2 wherein said second region completely overlies the surface of said first region of said semiconductor layer.

4. The Hall effect device of Claim 3 wherein said substrate is P-type, said semiconductor layer is N-type, said isolation region and said second region are P+ -type, and said third regions are N+ -type conductivities.

5. A Hall effect device comprising:

a semiconductor substrate of one conductivity type;

a semiconductor layer of the opposite conductivity type overlying said substrate;

a first region of said one conductivity type formed in said semiconductor layer extending to the surface of said substrate, wherein said first region surrounds and forms an isolated second region in said semiconductor layer;

a third region of said one conductivity type formed in the surface of said second region; and

a plurality of spaced apart fourth regions of said opposite conductivity type formed in said third region wherein said fourth regions extend below the lower surface of said third region to contact said second region, said fourth regions forming the current and voltage sense contacts of said Hall effect device.

6. The Hall effect device of Claim 5 wherein said third region completely overlies the surface of said second region.

7. The Hall effect device of Claim 6 wherein said substrate is P-type, said semiconductor layer is N-type, said first and third regions are P+ -type, and said fourth regions are N+ -type conductivities.

8. A method of fabricating an integrated Hall effect device comprising the steps of:

forming a semiconductor substrate of one conductivity type;

forming an epitaxial semiconductor layer of the opposite conductivity type overlying said substrate;

forming a first region in said epitaxial layer extending to the surface of said substrate to form an isolated second region of said epitaxial layer;

forming a third region of said one conductivity type in the surface of said second region; and

forming a plurality of spaced apart fourth regions of said opposite conductivity type in said third region wherein said fourth regions extend below the lower surface of said third region to contact said second region.

9. The method of Claim 8 wherein said step of forming said first region comprises:

forming a patterned masking layer overlying said epitaxial layer; and

doping said epitaxial layer through said patterned masking layer to form said first region of said one conductivity type extending from the surface of said epitaxial layer to the surface of said substrate.

10. The method of Claim 9 wherein said step of forming said third region comprises:

forming a patterned masking layer overlying said epitaxial layer to expose the surface of said second region and a portion of said first region; and

doping said exposed area to form said third region of said one conductivity type extending a predetermined depth below the surface of said second region.

11. The method of Claim 10, further comprising:

forming a relatively thin insulating over said exposed area; and implanting said dopant through said thin insulating layer.

12. The method of Claim 8, further comprising:

forming a patterned insulating layer overlying said epitaxial layer to expose said plurality of fourth regions; and

forming a patterned conductive layer overlying said insulating layer to contact said fourth regions.

Fig.1 (PRIOR ART)

Fig.2 (PRIOR ART)

*Fig.3*

*Fig.4*

*Fig.5*

*Fig. 6*

*Fig. 7*

POTENTIAL

NEUTRAL
EPITAXIAL
REGION

$V_c$  $V_b$

DISTANCE FROM SiO₂ SURFACE

*Fig. 8*